# EUROPEAN PATENT SPECIFICATION

(11) **EP 1 425 594 B1**
(45) Date of publication and mention of the grant of the patent: **29.11.2006**
(21) Application number: 02798942.5
(22) Date of filing: 09.09.2002
(51) Int. Cl.: G01R 31/28, G01R 31/26, G06F 11/00

(54) **MULTILEVEL SIGNAL INTERFACE TESTING WITH BINARY TEST APPARATUS BY EMULATION OF MULTILEVEL SIGNALS**
MEHRPEGELSIGNALSCHNITTSTELLENPRÜFUNG MIT BINÄRER PRÜFVORRICHTUNG DURCH EMULATION VON MEHRPEGELSIGNALEN
APPAREIL D'ESSAI BINAIRE EMULANT DES SIGNAUX MULTINIVEAUX POUR TESTER DES INTERFACES DE SIGNAUX MULTINIVEAUX

(30) Priority: 14.09.2001 US 953486; 14.09.2001 US 953514
(43) Date of publication of application: 09.06.2004
(73) Proprietor: RAMBUS INC., Los Altos, California 94022 (US)
(72) Inventor: WERNER, Carl, W., Los Gatos, CA 95032 (US); ZERBE, Jared, L., Woodside, CA 94062 (US); STOENCYPHER, William, F., San Jose, CA 95118 (US); LIAW, Haw-Jyh, Fremont, CA 94539 (US); CHANG, Timothy, C., Saratoga, CA 95070 (US)
(74) Representative: Eisenführ, Speiser & Partner
(86) International application number: PCT/US2002/028631
(87) International publication number: WO 2003/025600

(56) References cited:
- US-A- 5 097 144
- US-A- 6 055 661
- US-B1- 6 175 939
- US-B1- 6 275 962
- US-B1- 6 452 411

## Description

### BACKGROUND OF THE INVENTION

The present invention relates to multilevel digital signaling, and in particular to techniques to test for errors that may occur in a multilevel, multi-line signaling system.

The use of multiple signal levels instead of binary signal levels is a known technique for increasing the data rate of a digital signaling system, without necessarily increasing the signal frequency of the system. Such multilevel signaling is sometimes known as multiple pulse amplitude modulation or multi-PAM, and has been implemented with radio or other long-distance wireless signaling systems.

Other long-distance uses for multi-PAM signaling include computer or telecommunication systems that employ Gigabit Ethernet over optical fiber (IEEE 802.3z) and over copper wires (IEEE 802.3ab), which use three and five signal levels, respectively, spaced symmetrically about and including ground.

Multi-PAM has not traditionally been used for communication between devices in close proximity or belonging to the same system, such as those connected to the same integrated circuit (IC) or printed circuit board (PCB). One reason for this may be that within such a system the characteristics of transmission lines, such as buses or signal lines, over which signals travel are tightly controlled, so that increases in data rate may be achieved by simply increasing data frequency. At higher frequencies, however, receiving devices may have a reduced ability to distinguish binary signals, so that dividing signals into smaller levels for multi-PAM is problematic. Multi-PAM may also be more difficult to implement in multi-drop bus systems (i.e., buses shared by multiple processing mechanisms), since the lower signal-to-noise ratio for such systems sometimes results in bit errors even for binary signals.

Testing of a multi-PAM device is also problematic, since test apparatuses are typically designed for testing binary signals. Thus, in addition to the complexities of designing a multi-PAM device, there may not be conventional means for testing a multi-PAM device to ensure that the device operates free of errors.

US Patent 5,097,144 relates to a driver circuit for use in testing binary bidirectional semiconductor devices. The DUT (Device Under Test) is a conventional binary device having only two signal levels (high and low). A signal having three states (high, low, middle) is used for test purposes of the conventional I/O port for efficient testing.

### SUMMARY

The present invention is directed to error detection mechanisms for multilevel signal interfaces. Such error detection mechanisms may involve translating between the multilevel signals of an interface and binary signals of a test apparatus. The error detection mechanisms may be particularly advantageous for testing integrated circuits designed to communicate according to multi-PAM signals over printed circuit boards.

### BRIEF DESCRIPTION OF THE FIGURES

FIG. 1 is a diagram of a multilevel signaling system having four logical states corresponding to four voltage ranges.
FIG. 2 is a diagram of a representative multilevel signaling device that may be used to create the voltage levels of FIG. 1.
FIG. 3 is a diagram of a differential 4-PAM signaling system.
FIG. 4A is a diagram of a pair of encoders translating binary signals into multiplexed control signals for the multilevel signaling device of FIG. 2.
FIG. 4B is a diagram of one of the encoders of FIG. 4A that encodes MSB even and LSB even signals into control signals.
FIG. 5A is a diagram of a receiver and decoder that receives the multilevel signals sent by the signaling device of FIG. 2 and decodes the signals into binary MSB even and LSB even components.
FIG. 5B is a diagram of the receiver and decoder of FIG. 5A along with another receiver and decoder that receive the multilevel signals sent by the signaling device of FIG. 2 and decode the signals into binary MSB and LSB even and odd components.
FIG. 6 is a functional block diagram of a device including a multilevel signal interface coupled to a memory.
FIG. 7 is a functional block diagram of a system for testing the device of FIG. 6 with a binary test apparatus and a test interface.
FIG. 8 is a voltage and timing diagram showing that a 4-PAM signal has six possible distinct 2-PAM transitions.
FIG. 9 is a voltage and timing diagram showing six passes that may be used to test a 4-PAM signal interface with a 2-PAM test apparatus.
FIG. 10 is a voltage and timing diagram showing the result of selectively superimposing eye patterns from the six passes of FIG. 9 to test for 4-PAM signals with 2-PAM eye patterns.
FIG. 11 is a block diagram of a binary test system with a test interface configured for testing a device under test (DUT) having a multilevel signal interface.
FIG. 12 is a schematic diagram of part of the system of FIG. 11 showing impedance matching for reduced signal reflections.
FIG. 13 is a schematic diagram of part of the system of FIG. 11 showing impedance matching of test receivers for reduced signal reflections.
FIG. 14 is a schematic diagram of a receiver of FIG. 11, FIG. 12 or FIG. 13 that can detect dual voltage levels.
FIG. 15A is a schematic diagram of a first embodiment of a power splitter that can be used in the test interface of FIG. 11 and FIG. 12 to convert binary test signals into 4-PAM test signals.
FIG. 15B is a schematic diagram of a second embodiment of a power splitter that can be used in the test interface of FIG. 11 and FIG. 12 to convert binary test signals into 4-PAM test signals.
FIG. 16A is a schematic diagram of a first embodiment of a matched attenuator that can be used in the test interface of FIG. 11 and FIG. 12 to reduce signal reflection.
FIG. 16B is a schematic diagram of a second embodiment of a matched attenuator that can be used in the test interface of FIG. 11 and FIG. 12 to reduce signal reflection.
FIG. 16C is a schematic diagram of a third embodiment of a matched attenuator that can be used in the test interface of FIG. 11 and FIG. 12 to reduce signal reflection.
FIG. 17 is a block diagram of a binary test system with a test interface including circuitry configured for testing a DUT having a multilevel signal interface.

### DETAILED DESCRIPTION OF THE PREFERRED EMBODIMENT

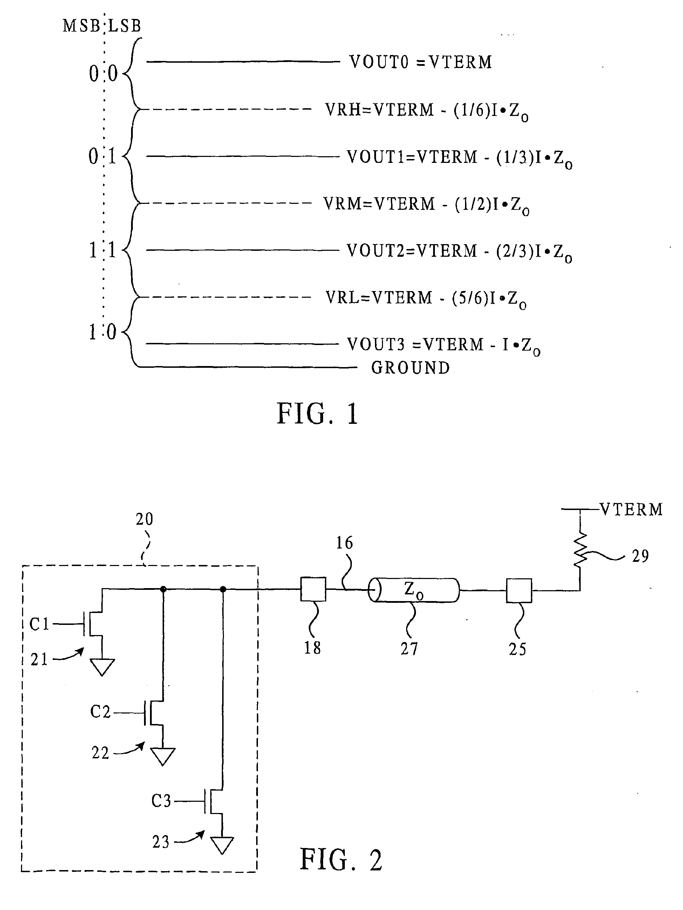

FIG. 1 shows a multilevel signal system having four logical states corresponding to four distinct voltage levels, VOUT0, VOUT1, VOUT2 and VOUT3. The voltage levels in this example are all positive relative to ground, and range as high as VTERM. VOLTT0 is defined to be above VREFH, VOUT1 is defined to be between VREFM and VREFH, VOUT2 is defined to be between VREFL and VREFM, and VOUT3 is defined to be less than VREFL. VOUT0 corresponds to logical state 00, VOUT1 corresponds to logical state 01, VOUT2 corresponds to logical state 11, and VOUT3 corresponds to logical state 10. An example of the 4-PAM system described above has been implemented for a memory system interface having VOUT0=1.80V, VOUT1=1.533V, VOUT2=1.266V and VOUT3=1.00V. Although four logical states are illustrated in this example, a multilevel signal system may have more or less logical states, with at least two reference levels serving as boundaries between the states.

A first bit of each logical state is termed the most significant bit (MSB) and a second bit of each logical state is termed the least significant bit (LSB). Each logical state may be termed a symbol, since it provides information regarding more than one bit. Data may be transmitted and read at both rising and falling edge of a clock cycle, so that each bit signal and each dual-bit signal has a duration of one-half the clock cycle. The logical states are arranged in a Gray coded order, so that an erroneous reading of an adjacent logic state produces an error in only one of the bits. Another characteristic of this logical 4-PAM arrangement is that setting the LSB equal to zero for all states results in a 2-PAM scheme. Alternatively, the logical states can be arranged in numerical (00, 01, 10, 11) or other order.

In one embodiment the communication system is employed for a memory bus that may for instance include random access memory (RAM), like that disclosed in U.S. Patent Number 5,243,703 to Farmwald et al.. The multi-PAM communication and testing techniques disclosed herein may also be used for other contained systems, such as for communication between processors of a multiprocessor apparatus, or between a processor and a peripheral device, such as a disk drive controller or network interface card over an input/output bus.

FIG. 2 shows a representation of a communication system that may be used to create the voltage levels of FIG. 1. An output driver 20 drives signals to output pad 18 and over transmission line 16, which may for example be a memory bus or other interconnection between devices affixed to a circuit board, to be received at pad 25. Transmission line 16 has a characteristic impedance Z₀ 27 that is substantially matched with a terminating resistor 29 to minimize reflections.

Output driver 20 includes first 21, second 22 and third 23 transistor current sources, which together produce a current I when all are active, pulling the voltage at pad 25 down from VTERM by I·Z₀, signaling logical state 10 under the Gray code system. Control signal input through lines C1, C2 and C3 switch respective current sources 21, 22 and 23 on and off. To produce voltage VOUT0=VTERM, signaling logical state 00, current sources 21, 22 and 23 are all turned off. To produce voltage VOUT1=VTERM-(1/3)I·Z₀, signaling logical state 01, one of the current sources is turned on, and to produce voltage VOUT2=VTERM-(2/3)I·Z₀, two of the current sources are turned on. The logical level 00 is chosen to have zero current flow to reduce power consumption for the situation in which much of the data transmitted has a MSB and LSB of zero. The reference levels are set halfway between the signal levels, so that VREFH=VTERM-(1/6) I·Z₀, VREFM=VTERM-(1/2) I·Z₀ and VREFL=VTERM(5/6) I·Z₀.

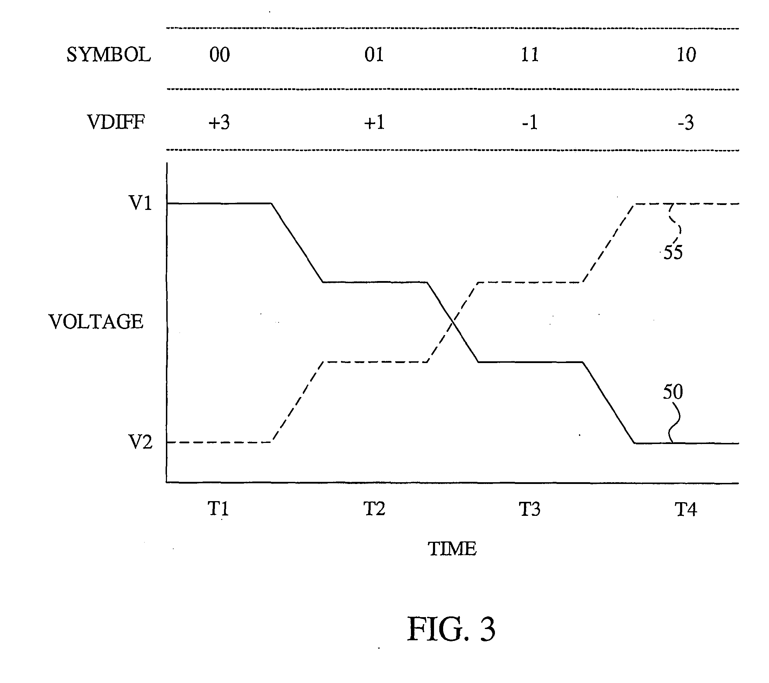

FIG. 3 shows an example of a differential 4-PAM signaling system where data is encoded on two wires or other transmission media and a symbol value is determined by the voltage difference as measured by a receiver. The use of differential signaling can provide increased immunity to noise and crosstalk. A voltage V1 on one of the wires varies over time between four voltage levels, as shown with solid line 50, while a voltage V2 on the other wire also varies between the four voltage levels but in a complementary fashion, as shown with broken line 55. Voltage differences VDIFF between voltages V1 and V2 for times T1, T2, T3 and T4 are listed above the signals in arbitrary units as +3, +1, -1 and -3, respectively. The MSB and LSB symbols corresponding to the voltage differences are listed above the signals in Gray coded sequence.

Another example of a multilevel signaling apparatus and method is disclosed in U.S. Patent Number 6,005,895 to Perino et al. This and other types of multilevel signal interfaces may also be tested in accordance with the present invention. Also incorporated by reference herein is a U.S. Patent application published as US 2003-0070126 A1 that discloses other means for testing multilevel signal interfaces, entitled "Built-In Self-Testing of Multilevel Signal Interfaces," filed on the same date as the present application and by inventors Werner, Zerbe and Stonecypher of the present application.

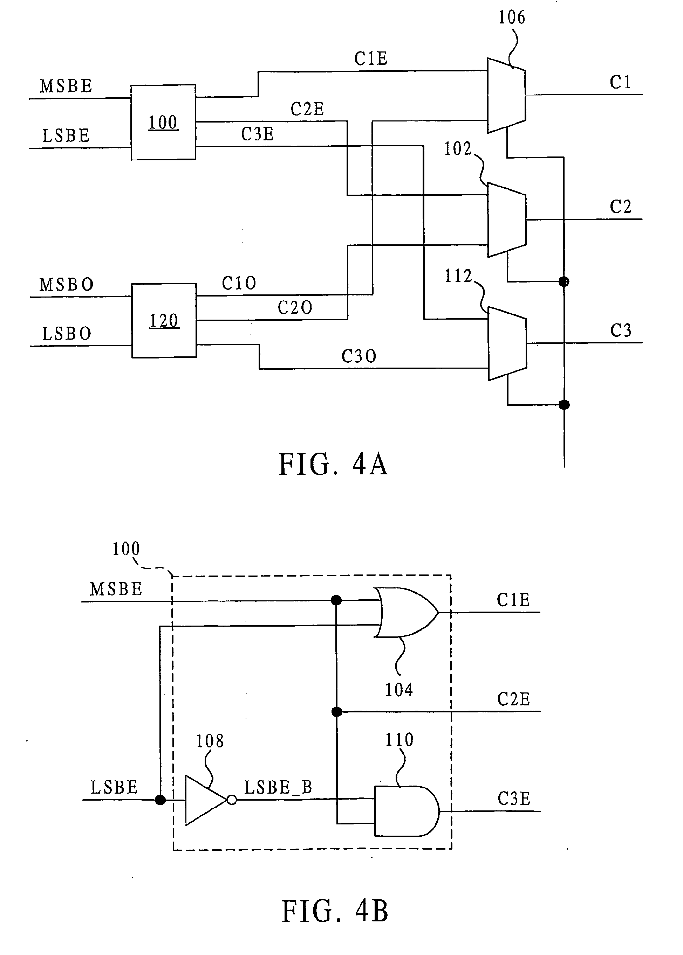

FIG. 4A shows an embodiment for which data is transmitted and read at both rising and falling clock edges, using a pair of substantially identical encoders 100 and 120 translating MSB and LSB odd and even signals into the control signals on lines C1, C2 and C3 for output driver 20. MSB even and LSB even signals on lines MSBE and LSBE are input to encoder 100, which outputs thermometer code signals on lines C1E, C2E and C3E. Similarly, and MSB odd and LSB odd signals on lines MSBO and LSBO are input to encoder 120, which outputs thermometer code signals on lines C1O, C2O and C3O. Lines C1E and C1O input to multiplexer 106, lines C2E and C2O input to multiplexer 102, and lines C3E and C3O input to multiplexer 112. Multiplexers 102, 106 and 112 select the odd or even signals according to a clock select signal on select line 118, outputting the thermometer code control signals on lines C1, C2 and C3.

Encoder 100 is shown in more detail in FIG. 4B. MSBE is connected to line C2E. MSBE is also input to an OR gate 104 that has LSBE as its other input, with the output of OR gate 104 connected to line C1E. Signals on line LSBE pass through inverter 108, with the inverted signals on line LSBE_B input to AND gate 110. AND gate 110 receives as its other input line MSBE, with its output connected to line C3E providing a third control signal.

Table 1 illustrates the correspondence between MSB and LSB signals and the control signals on lines C1, C2 and C3 that translate binary signals into 4-PAM signals.

**Table 1**

| MSB | LSB | C1 | C2 | C3 |
|---|---|---|---|---|
| 0 | 0 | 0 | 0 | 0 |
| 0 | 1 | 1 | 0 | 0 |
| 1 | 1 | 1 | 1 | 0 |
| 1 | 0 | 1 | 1 | 1 |

For example, when MSB=0 and LSB=0, all the control signals are off. When MSB=0 and LSB=1, the OR gate 104 outputs on, so that the control signal on line C1 is on, but control signals on lines C2 and C3 are still off. When both MSB=1 and LSB=1, control signals on lines C1 and C2 are on, but due to inverted LSB signals input to AND gates such as AND gate 110, the control signal on line C3 is off. When MSB=1 and LSB=0, control signals on all the lines C1, C2 and C3 are turned on. In this fashion the MSB and LSB may be combined as Gray code and translated to thermometer code control signals on lines C1, C2 and C3 that control the current sources to drive 4-PAM signals.

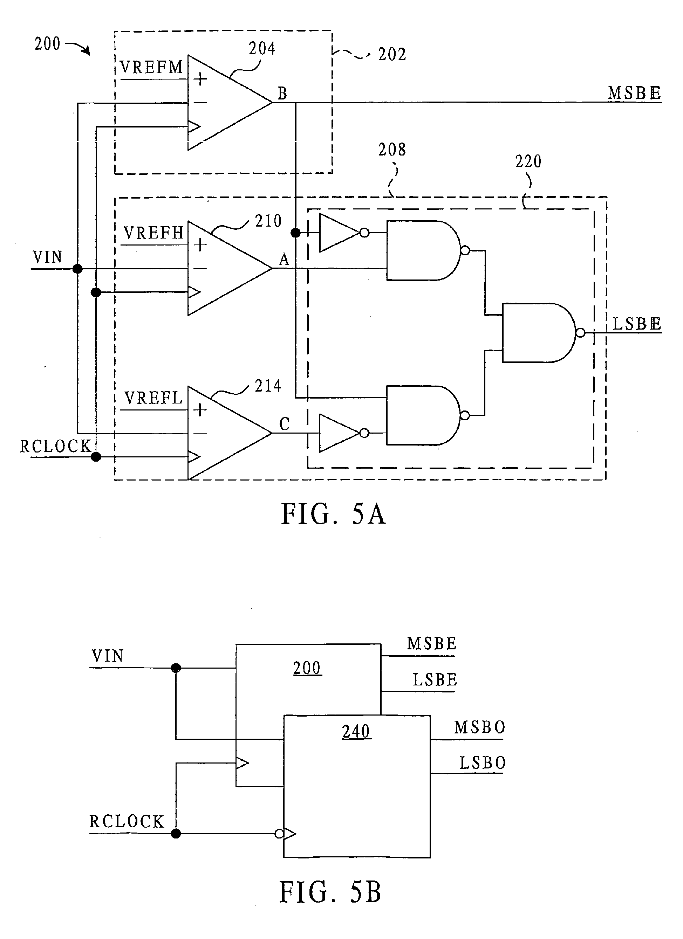

FIG. 5A shows one possible embodiment of a receiver 200 that may be used to receive the multilevel signals sent by drivers such as those described above, and decode the signals into MSBE and LSBE components. As mentioned above, the data may be transmitted at twice the clock frequency, and a substantially identical receiver 240 is shown in FIG. 5B, with receivers 200 and 240 reading even and odd data, respectively.

An MSBE receiver 202 of the 4-PAM receiver 200 in this example receives and decodes a 4-PAM input signal VIN by determining whether the signal VIN is greater or less than VREFM. In the MSBE receiver 202, a latching comparator 204 compares the value of the voltage of the received input signal VIN to the reference voltage VREFM and latches the value of the result of the comparison B in response to a receive clock signal RCLOCK. Although this embodiment discloses data sampling at both rising and falling clock edges, data may alternatively be sampled at only the rising clock edges or only the falling clock edges.

In an LSBE receiver 208, two latching comparators 210 and 214 compare the value of the voltage of the received input signal VIN to the reference voltages VREFH and VREFL, and latch the value of the result of the comparison A and C, respectively, in response to the receive clock signal. To decode the LSBE, the signals from the comparator outputs B, A, and C are then passed through combinational logic 220. The latching comparators 204, 210 and 214 may be implemented as integrating receivers to reduce the sensitivity of the output signals to noise. This can be accomplished by integrating the difference between the received signal, Vin, and the three respective reference voltages over most or all of the bit cycle, and then latching the integrated results as the outputs A, B and C. Related disclosure of a multi-PAM signaling system can be found in U.S. Patent Application Serial Number 09/478,916, entitled "Low Latency Multi-Level Communication Interface," filed on January 6, 2000 (not yet published at filing date of present application).

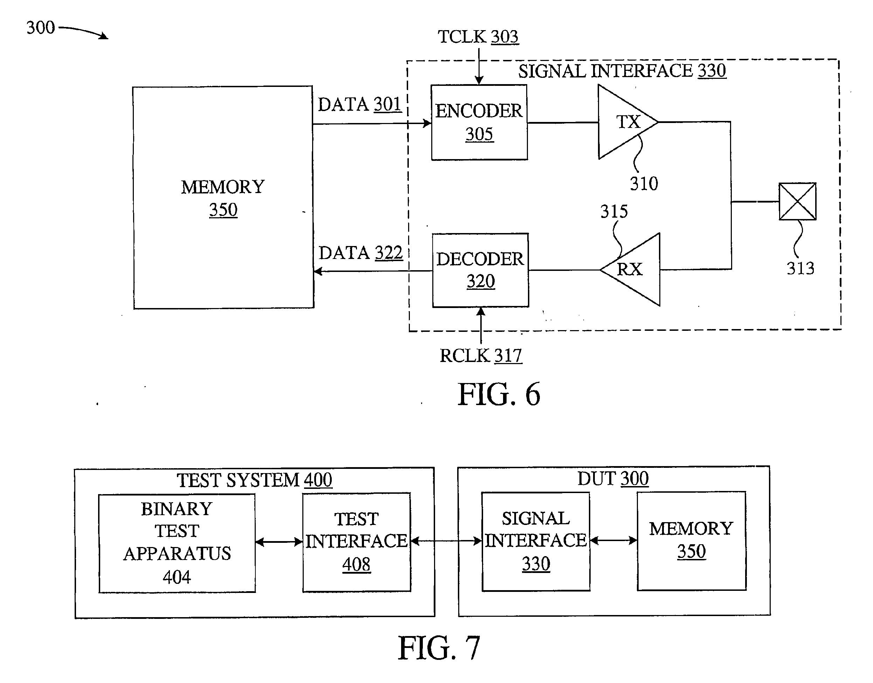

FIG. 6 shows a functional block diagram of one type of device 300 including a multilevel signal interface 330 coupled to a memory 350, both of which may be tested in accordance with the present invention. Memory 350 may store binary or other forms of data using semiconductor, magnetic, optical, ferroelectric or other known means for storage. Data signals 301 from memory 350 are clocked with transmit clock signals 303 and encoded at encoder 305, which provides control signals to output driver 310. Multilevel signals are transmitted by output driver 310 to input/output pin 313. Encoder 305 and output driver 310 may be similar to encoder 100 and output driver 20 described previously, and input/output pin 313 may represent pads 18 or 25 described above, for example. Also coupled to input/output pin 313 is receiver 315, which is adapted to receive multilevel signals from pin 313. The output of receiver 315 is clocked with receive clock signals 317 and decoded into binary signals at decoder 320 to be output as data 322. Receiver 315 and decoder 320 may be similar to receiver 200 described previously.

FIG. 7 illustrates a system 400 for testing the device 300, which may be termed a device under test (DUT), with a binary test apparatus 404 and a test interface 408. Test apparatus 404 may be conventional, such as model number 83000 or 95000 High Speed Memory tester, available from Agilent Technologies, Palo Alto, California, and designed for testing devices employing binary signals. Test interface 408 may be a printed circuit board adapted to provide electrical and mechanical connections between test apparatus 404 and DUT 300, and may be termed a load board. Examples such load boards are described in U.S Patent No. 5,686,833 to Spinner.

As mentioned above, DUT 300 contains a multilevel signal interface 330 and memory 350. Device 300 may include many additional transmitters and receivers for communicating binary or multilevel signals via associated input/output pins although, to promote clarity, those additional elements are not shown in this diagram. Communication of binary signals with a multilevel signal interface can be accomplished by use of appropriate control signals, for example by setting LSB equal to zero for all states input to the encoder 100 and output driver 20 described previously. Alternatively, at least one transceiver or transmitter/receiver pair may be devoted exclusively to binary communication.

In either case, the DUT 300 may be tested for errors in binary signals as well as tested for errors in multilevel signals. This testing of binary and multilevel signals can be done during the same or different insertions of DUT 300 into load board 408. For the case in which the binary and multilevel signals are tested during the same insertion of DUT 300 into load board 408, the binary testing can be performed at one time, and the multilevel testing performed at another time.

Either binary or multilevel signals may be characterized by an "eye" diagram. The eye diagram represents the ranges of transmissions voltages and signal transmission times for which data transmission is successful. The width of each eye represents the range of signal transition times, compared to an ideal center time, which still results in successful data transmission. The height of each eye represents the amount of voltage error and noise that a DUT can tolerate, as compared with an ideal central voltage level.

Testing determines the range of transmission voltages and signal transition times for which the DUT can successfully receive data and compares this region to some voltage and timing criteria appropriate for the system. Receiver testing may be done by repeatedly sending data to the DUT using different transmission voltages and signal transmission times and measuring the region for which transmission was successful.

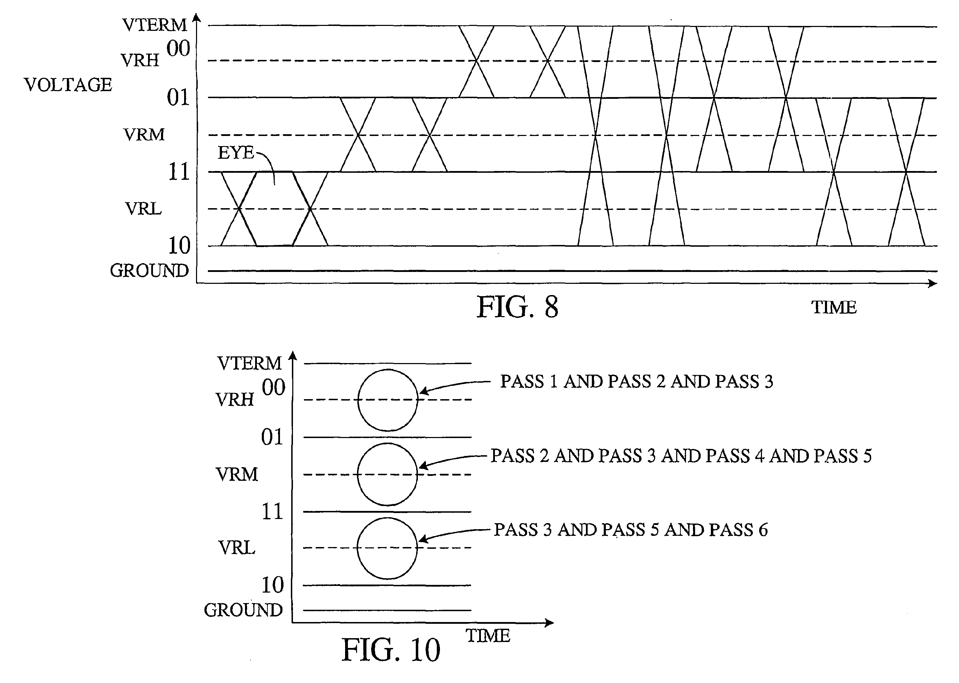

As shown in FIG. 8, a 4-PAM signal has six possible distinct 2-PAM transitions. Each of these transitions will have a characteristic "eye" pattern. Receiver testing may be done by individually measuring the six "eyes" and comparing each of them to voltage and timing criteria.

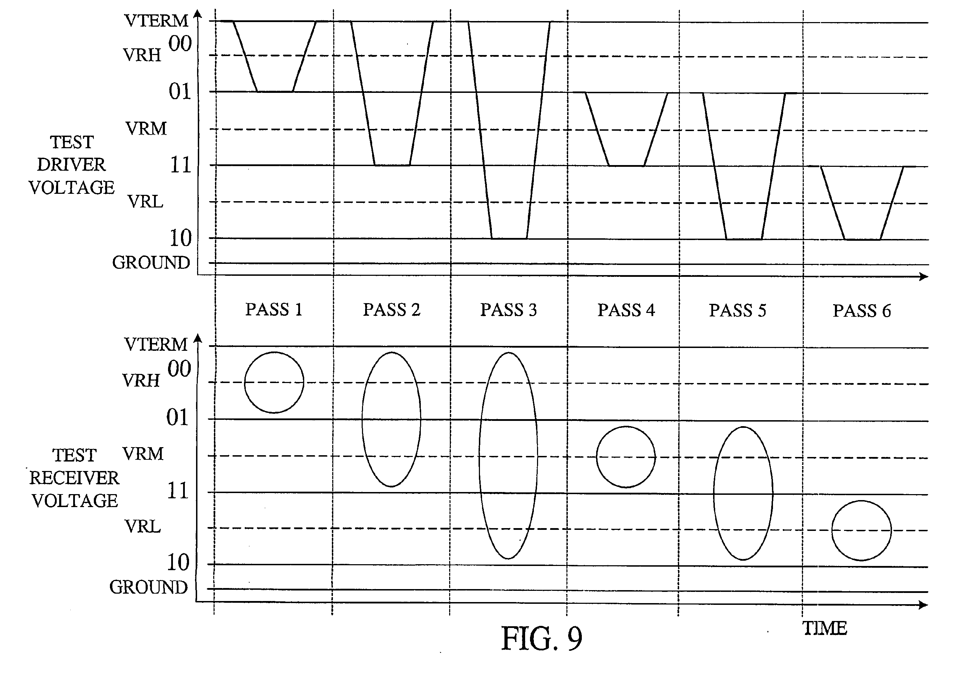

FIG. 9 shows six passes that may be used to test a 4-PAM signal interface with a 2-PAM test apparatus 404. In an upper portion of FIG. 9, a series of transition signal levels generated by the test apparatus 404 are shown. In a lower portion of FIG. 9 the eye diagrams at the test apparatus 404 for signals received from the DUT 300 are shown. Each of the six 2-PAM sequences can be tested by varying each of the receive reference levels that a signal transition crosses, while holding the others constant. In this case, pass 3 is read three times while a different one of VRH, VRM and VRL are varied during each pass. Pass 2 is read once while VRH is varied and once while VRM is varied. Similarly, pass 5 is read once while VRM is varied and once while VRL is varied. Passes 1, 4, and 6 need only be tested by varying one of the three references. In total, six 2-PAM sequences are tested a total of ten times. Table 2 lists MSB and LSB values for the passes, as well as the reference levels that are checked, with those that are not checked being marked with an X.

**Table 2**

| Pass 1 | Pass 2 | Pass 3 | Pass 4 | Pass 5 | Pass 6 |
|---|---|---|---|---|---|
| MSB=0 | MSB=LSB | LSB=0 | LSB=1 | LSB=MSB | MSB=1 |

| VRH | VRH | VRH | X | X | X |
|---|---|---|---|---|---|
| X | VRM | VRM | VRM | VRM | X |
| X | X | VRL | X | VRL | VRL |

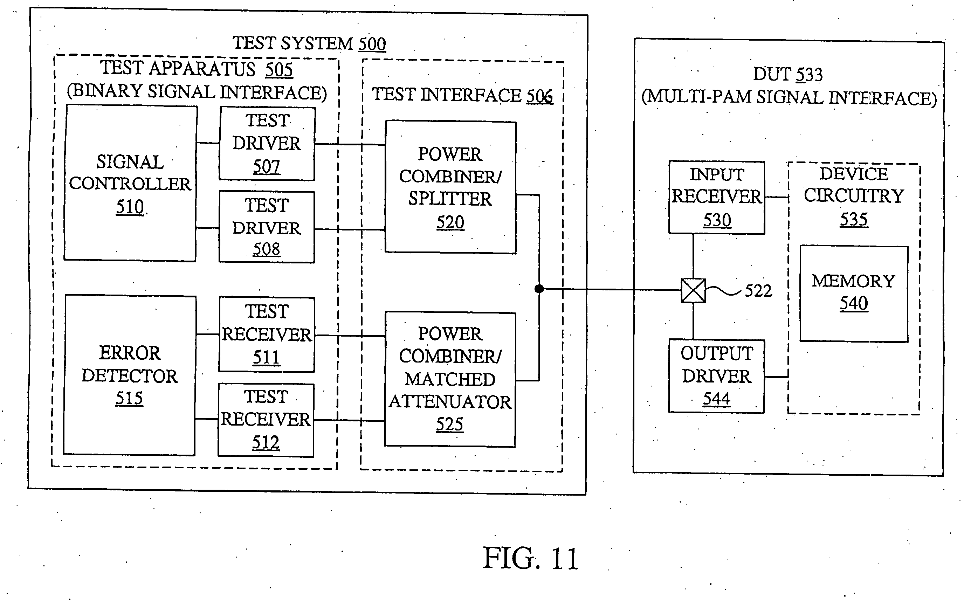

As shown in FIG. 10, after determining the eyes for each transition, the corresponding eye patterns from the various passes may be superimposed (e.g., logically ANDed together) to generate overall DUT performance characteristics. Alternatively, a sequence of test signals generated by test apparatus 404 may be stored in the memory 350 of the DUT 300 and then transmitted repeatedly from the DUT to the test apparatus, which is programmed to detect different levels of binary signals each time the sequence is received.

FIG. 11 is a block diagram of another test system 500 for testing DUT 300. The test system 500 includes a conventional test apparatus 505 designed for testing devices employing binary signals, such as described above. The test apparatus 505 may have one or more test drivers 507 and 508 that output binary signals based upon inputs from a signal controller 510. Similarly, test apparatus 505 may have one or more test receivers 511 and 512 that categorize signals received from a DUT as binary signals. The binary signals are output from test receivers 511 and/or 512 to an error detector mechanism 515, which compares the signals with those expected in accordance with signal controller 510, and generates an error signal when the signals from receivers differ from those expected. For example, signal controller 510 may be a program executed by the test apparatus 505, including a sequence of digital signals designed to test for errors in DUT 300. A comparison mechanism of error detector 515, such as a plurality of comparitors or a plurality of XOR or XNOR gates, can then determine whether the binary sequence received by test receivers 511 and 512 matches the binary sequence earlier output by test drivers 507 and 508. Alternatively, error detector 515 may be a part of a test program executing on apperatus 505.

In one embodiment the signal controller 510 can produce a pseudo random bit sequence (PRBS), optionally via software, for testing with a detector in DUT 300 coupled to a linear feedback shift register (LFSR) on the DUT 300. Conversely, DUT 300 may produce a PRBS signal and the test receivers 511 and 512 check the received sequence against a program provided to error detector 515. In this manner the input receiver 530 and output driver can be independently tested without using memory 540.

In a conventional implementation, in contrast to that shown in FIG. 11, a first test driver would output a first binary signal to a first pin of a DUT, while a second test driver would output a second binary signal to a second pin of a DUT. In the embodiment shown in FIG. 11, however, test interface 505 includes a matched impedance summer 520, also known as power combiner or power splitter, that sums the signals from test drivers 507 and 508 to produce a multilevel signal that is output to I/O pin 522 of DUT 533. MSB and LSB control signals are input to test drivers 507 and 508 which output binary signals that are summed at power combiner/splitter 520 to form 4-PAM signals that are sent to DUT 533. The MSB test driver 507 outputs twice the voltage of the LSB test driver 508 to correctly weight the 4-PAM signal in this embodiment.

A multilevel input receiver 530 of DUT 533 decodes the multilevel signal and outputs a sequence of binary signals to memory 540. DUT 533 thus can store the multilevel signal received from test system 500, and then output that multilevel signal repeatedly for testing by at least one of the binary test receivers 511 and 512, with the test receivers measuring a different binary threshold when the multilevel signal is repeated. To do this, output driver 544 encodes the sequence of binary signals output by memory 540 and transmits the resulting multilevel signal to test interface 506 which is coupled to test receivers 511 and 512. Test receivers 511 and 512 can be set to different voltage levels, to decode the multilevel signal they received into binary MSB and LSB components that are validated by error detector 515. An optional power combiner 525 is provided on test interface 506 that also serves as a matched attenuator to minimize reflections of the signals output by power combiner 520.

As an example, during a first sequence of signals from memory 540, test receiver 511 can be set to have a binary threshold that matches VREFH of the 4-PAM signal system shown in FIG. 1. During a second sequence of signals from memory 540, test receiver 511 can be set to have a binary threshold that matches VREFM, and during a sequence of signals from memory 540, test receiver 511 can be set to have a binary threshold that matches VREFL. The binary output of test receiver 511 can then be compared by error detector 515 with an expected pattern determined by the sequence of signals input into test drivers 507 and 508.

Table 3 shows the logic levels at various locations in the system of FIG. 11 that correspond to 4-PAM voltage levels ranging between 1.0V and 1.8V, inclusive, the 4-PAM voltage levels listed in the left column of the table.

**Table 3**

| | CONTROL | | TEST DRIVER | | TEST RECEIVER | | |
|---|---|---|---|---|---|---|---|
| 4-PAM V₀ | SIGNALS | | INPUTS | | EXPECTED DATA | | |
| (V) | MSB | LSB | 507 | 508 | VREFH | VREFM | VREFL |
| 1.800 | 0 | 0 | 1 | 1 | 1 | 1 | 1 |
| 1.533 | 0 | 1 | 1 | 0 | 0 | 1 | 1 |
| 1.266 | 1 | 1 | 0 | 1 | 0 | 0 | 1 |
| 1.00 | 1 | 0 | 0 | 0 | 0 | 0 | 0 |

Gray coded MSB and LSB logic levels of DUT 533 corresponding to the four voltage levels 1.0V, 1.266V, 1.533V and 1.8V, are shown in a second column. Control signals shown in a third column are input into test drivers 507 and 508 to create the four voltages, with the MSB voltage output from driver 507 weighted twice that of the LSB voltage output from driver 508, as described above. Digital test receiver inputs for the 4-PAM signals need to differentiate between three reference levels VREFH, VREFM and VREFL, as described above, and the binary logic corresponding to those level is shown in a fourth column of TABLE 3. Other coding schemes are possible; for example column 2 may be binary rather than Gray coded. Also, a system where signals swing symmetrically above or below a reference voltage may require different symbol mappings in columns 3 and 4.

Test receivers 511 and 512 can both receive signals from a single pin of the DUT and can be set to different binary thresholds, so that testing of DUT 533 for errors in a sequence of combined signals transmitted by test drivers 507 and 508 can be accomplished in only two transmissions of that sequence from DUT to test receivers. For example, in a first transmission of the sequence from DUT 533 to test apparatus 505, receiver 511 can be set to VREFH and receiver 512 can be set to VREFM. During a second transmission of the sequence from DUT 533 to test apparatus 505, receiver 511 can be set to VREFM and receiver 512 can be set to VREFL. Connection of a third test receiver to the DUT pin, in addition to test receivers 511 and 512, allows testing to proceed without repeatedly transmitting the sequence from memory. Certain test apparatuses (e.g., Agilent Technologies 95000 High Speed Memory tester) have receivers that can each look at two voltage levels, VOH and VOL, so that one of those receivers can analyze a sequence of 4-PAM signals input to DUT 533 from test system 500 by transmitting that sequence from output driver 544 twice. Alternatively, two such dual-voltage digital receivers connected to a DUT pin can analyze 4-PAM signals without repeating those signals.

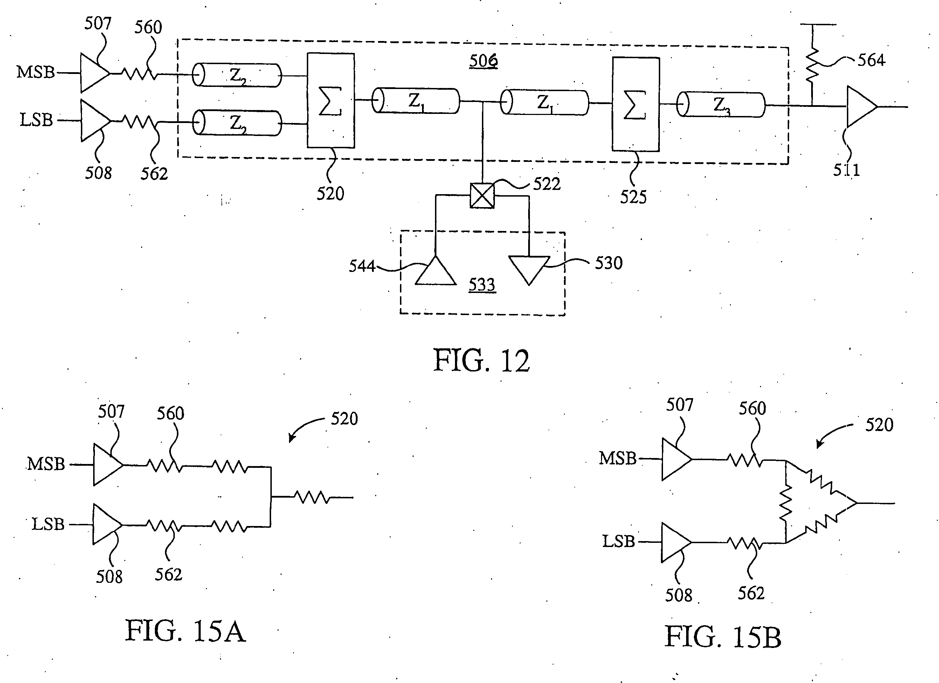

FIG. 12 shows a schematic diagram of part of the system shown in FIG. 11, including a configuration that reduces reflections during testing by impedance matching for test interface 506 DUT 533 and signal transmission lines. The impedance Z₁ of a portion of the test interface 506 connecting power combiner/splitter 520 with DUT 533 is substantially matched with the impedance Z₁ of DUT 533. Similarly matched is the impedance Z₁ of a portion of the test interface 506 connecting receiver 511 with DUT 533. Source resistors 560 and 562 are provided to match the impedance Z₂ of lines connecting test drivers 507 and 508 to power combiner/splitter 520. Receiver 511 provides termination for the signals from the power combiner/splitter 520 for the signals that fly by the DUT 533, with terminating resistor 564 matching the impedance Z₃ of the line connecting receiver 511 and power splitter/attenuator 525. Both MSB test driver 507 and LSB test driver 508 outputs are quadrupled relative to the desired voltage levels at DUT 533, to compensate for the voltage drop of power combiner/splitter 520 and the further drop due to the source impedance of the test interface 506. Table 4 shows the voltage levels at drivers 507 and 508 that provide the signal levels of Table 3 at the DUT pin.

**Table 4**

| | Vhigh | Vlow |
|---|---|---|
| MSB Driver | Vterm=1.8V | Vterm - 8/3 * Vswing= -0.333V |
| LSB Driver | Vterm=1.8V | Vterm - 4/3 * Vswing= 0.733V |

In an alternative embodiment, a differential 4-PAM signal such as shown in FIG. 3 may be provided by deploying two of the circuits of Fig 11 and then driving the MSB drivers and LSB drivers in a complementary manner.

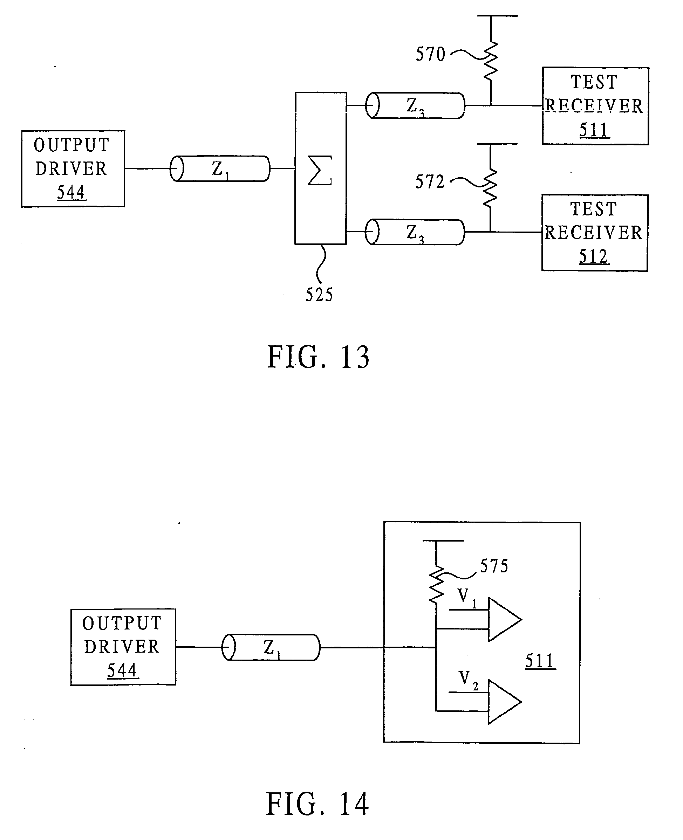

FIG. 13 shows an embodiment in which the test receivers 511 and 512 both receive the multilevel signals output by output driver 544 after distribution by power splitter 525. Resistors 570 and 572 are substantially matched to impedance Z₂ of lines connecting test receivers 511 and 512 to power combiner/attenuator 525.

FIG. 14 shows an embodiment in which receiver 511 can detect plural voltage levels, V₁ and V₂. Receiver 512, which is not shown in this figure, may also be able to detect plural voltage levels. Resistor 575 is provided to match the impedance Z₁ of lines connecting test receiver 511 and output driver 544, in the absence of power combiner/attenuator 525. For the situation in which the receiver 511 of FIG. 14 is used in the embodiment of FIG. 13, a 4-PAM signal transmitted by output driver 544 may be detected by receivers 511 and 512 without transmitting the signal repeatedly.

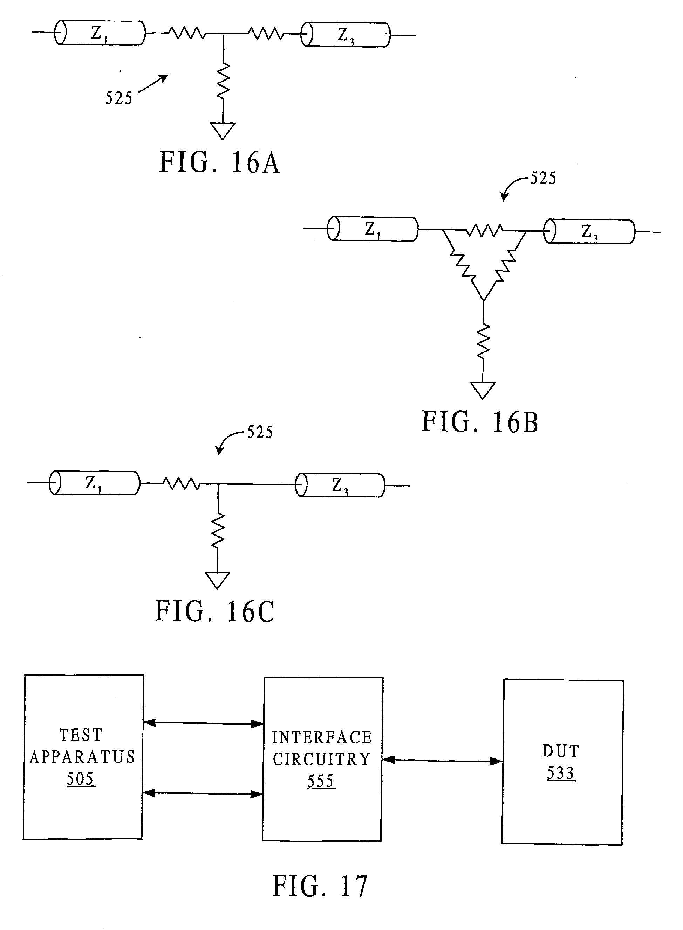

FIG. 15A shows a first example of a power combiner/splitter 520 that can be used with MSB test driver 507 and LSB test driver 508 to output a 4-PAM signal. FIG. 15B shows a second example of a power combiner/splitter 520 that can be used with MSB test driver 507 and LSB test driver 508 to output a 4-PAM signal.

Different matched attenuator embodiments of optional power splitter/attenuator 525 are shown in more detail in FIG. 16A, FIG. 16B and FIG. 16C, the first two of which are symmetric and the third of which is asymmetric. While the signal seen at receiver 511 would be reduced for the matched attenuator embodiment compared to the power splitter embodiment, load board resistors may provide a better termination and therefore reduce reflections when test drivers 507 and 508 write to DUT 533. Reducing reflections is important in a multilevel signaling system because reflected energy decreases voltage margins that have already been reduced by splitting the signal into multiple voltage levels.

In FIG. 17, interface circuitry 555 has been provided to convert multilevel signals from the DUT 533 to binary signals that are input into receivers at test apparatus 505. Interface circuitry 555 can also include circuits for converting binary signals from test apparatus 505 drivers to multilevel signals that are input into a receiver at DUT 533. Interface circuitry S55 may be provided as an integrated circuit (IC) chip and may include circuits similar to those shown in FIG. 4 and FIG. 5 for converting between binary signals of test apparatus 505 and multilevel signals of DUT 533.

Although we have focused on teaching the preferred embodiments of testing, with a binary test apparatus, a device including a multilevel signal interface, other embodiments and modifications of this invention will be apparent to persons of ordinary skill in the art in view of these teachings. Therefore, this invention is limited only by the following claims.

## Claims

1. A system (500) for testing a device (533) having a multi-PAM signal interface, the system (500) comprising:
a test apparatus (505) including a first test driver (507) configured to transmit binary signals, a first test receiver (511) configured to detect digital signals, and a comparison mechanism (515) configured to determine whether said digital signals match said binary signals,
the system (500) being **characterized by**
a multi-PAM test interface (506) coupled between the device (533) and said test apparatus (505) to convert said binary signals transmitted by said test apparatus (505) into a first set of multi-PAM signals at the device (533), to receive from the device (533) a second set of multi-PAM signals produced by the device (533), said second set of multi-PAM signals being based upon said first set of multi-PAM signals, to convert said second set of multi-PAM signals into said digital signals, and to provide said digital signals to said first test receiver (511),
wherein the device (533) is checked for errors.

2. The system (500) of claim 1, wherein:
said test apparatus (505) includes a second test driver (508) to transmit binary signals, and said test interface (506) includes circuitry to input said binary signals from said first and second test drivers (507, 508) and to output said first set of multi-PAM signals.

3. The system (500) of claim 1 or 2, comprising further:
a device (533) under test coupled to the test apparatus (505), wherein
the device (533) is adapted to store a representation of said first set of muiti-PAM signals,
the device (533) is adapted to transmit to said test interface (506) said second set of multi-PAM signals at least twice,
said test apparatus (505) is configured to detect a first level of digital signals during a first time that said second set of multi-PAM signals are transmitted, and
said test apparatus (505) is configured to detect a second level of digital signals during a second time that said second set of multi-PAM signals are transmitted.

4. The system (500) of claim 1, 2 or 3, wherein:
said first test receiver (511) is adapted to detect whether said second set of multi-PAM signals is above or below a reference voltage at a plurality of times, and
said reference voltage is set at a first level during a first detection of said second set of multi-PAM signals by said first test receiver (511), and
said reference voltage is set at a second level during a second detection of said second set of multi-PAM signals by said first test receiver (511).

5. The system (500) of any one of the preceding claims, wherein:
said test apparatus (505) includes a second test driver (508) configured to transmit binary signals, and
said test interface (506) includes a circuitry (520) adapted to combine signals output by said first and second test drivers (507,508),
such that a voltage output by said first test driver (507) is approximately twice that output by said second test driver (508).

6. The system (500) of claim 1, wherein:
said device (533) includes a receive mechanism (530) adapted to detect said first set of multi-PAM signals, and
said device (533) includes a transmit mechanism (544) coupled to said receive mechanism (530), said transmit mechanism (544) adapted to generate said second set of multi-PAM-signals.

7. The system (500) of claim 6, wherein:
said first test receiver (511) is adapted to receive said second set of multi-PAM signals by detecting whether said second set of multi-PAM signals is above or below a first voltage level during a first plurality of times,
said first test receiver (511) is adapted to detect a binary signal with a first voltage level during a first time period, and the device (533) is checked for errors by detecting said second set of multi-PAM signals with said first test receiver (511) set at different binary signal levels.

8. A method for testing a multi-PAM signal interface of a device (533) with a test apparatus (505), the method comprising:
transmitting, by the test apparatus (505), at least one sequence of binary signals,
converting the sequence of binary signals into a sequence of digital signals,
the method being **characterized by**:
receiving, by a signal interface of the device (533), the sequence of digital signals corresponding to said sequence of binary signals,
transmitting, by the multi-PAM signal interface of the device (533), a sequence of multi-PAM signals corresponding to said sequence of digital signals,
comparing, by the test apparatus (505), said sequence of multi-PAM signals with a first reference level, thereby obtaining a first series of results, and
comparing, by the test apparatus (505), said sequence of multi-PAM signals with a second reference level, thereby obtaining a second series of results.

9. The method of claim 8, further comprising storing, in a memory (540) associated with the multi-PAM signal interface, a representation of said sequence of multi-PAM signals.

10. The method of claim 8, further comprising:
comparing, by the test apparatus (505), said sequence of multi-PAM signals with a third reference level, thereby obtaining a third series of results.

11. The method of claim 8, wherein the sequence of digital signals is a sequence of multi-PAM signals.

12. The method according to one of claims 8 to 10, wherein
the first step of transmitting comprises transmitting of two binary sequences, and
the step of converting comprises combining the first and second sequences of binary signals into a sequence of digital signals, wherein the digital signal is a multi-PAM signal.

## Patentansprüche

1. System (500) zum Testen einer Vorrichtung (533), welches eine Multi-PAM-Signalschnittstelle aufweist, wobei das System (500) umfasst:
eine Testeinrichtung (505), welche einen ersten Testtreiber (507) beinhaltet, welcher ausgestaltet ist, um Binärsignale zu übertragen, einen ersten Testempfänger (511), welcher ausgestaltet ist, um digitale Signale zu detektieren und einen Vergleichsmechanismus (515), welcher ausgestaltet ist, um zu bestimmen, ob die Digitalsignale mit den Binärsignalen übereinstimmen,
wobei das System (500) **gekennzeichnet ist durch**
eine Multi-PAM-Testschnittstelle (506), die zwischen der Vorrichtung (533) und der Testeinrichtung (505) gekoppelt ist, um die von der Testeinrichtung (505) gesendeten Binärsignale in einen ersten Satz von Multi-PAM-Signalen in der Vorrichtung (533) umzuwandeln, um von der Vorrichtung (533) einen von der Vorrichtung (533) erzeugten zweiten Satz von Multi-PAM-Signalen zu empfangen, wobei der zweite Satz von Multi-PAM-Signalen auf dem ersten Satz von Multi-PAM-Signalen basiert, um den zweiten Satz von Multi-PAM-Signalen in die Digitalsignale umzuwandeln und um die Digitalsignale dem ersten Testempfänger (511) zuzuführen, wobei die Vorrichtung (533) auf Fehler geprüft wird.

2. System (500) nach Anspruch 1, wobei
die Testeinrichtung (505) einen zweiten Testtreiber (508) beinhaltet, um Binärsignale zu senden und die Testschnittstelle (506) einen Schaltkreis beinhaltet, um die Binärsignale den ersten und den zweiten Testtreibern (507, 508) einzugeben, und um den ersten Satz von Multi-PAM-Signalen auszugeben.

3. System (500) nach Anspruch 1 oder 2, ferner umfassend:
eine zu testende Vorrichtung (533), welche mit der Testeinrichtung (505) gekoppelt ist, wobei die Vorrichtung (533) ausgestaltet ist, um den zweiten Satz von Multi-PAM-Signalen mindestens zwei Mal an die Testschnittstelle (506) zu senden,
die Testeinrichtung (505) ausgestaltet ist, um einen ersten Pegel von Digitalsignalen während eines ersten Zeitraums zu detektieren, in dem der zweite Satz von Multi-PAM-Signalen gesendet wird, und
die Testeinrichtung (505) ausgestaltet ist, um einen zweiten Pegel von Digitalsignalen während eines zweiten Zeitraums zu detektieren, in dem der zweite Satz von Multi-PAM-Signalen gesendet wird.

4. System (500) nach Anspruch 1, 2 oder 3, wobei der erste Testempfänger (511) ausgestaltet ist, um zu detektieren, ob der zweite Satz von Multi-PAM-Signalen während der Mehrzahl von Zeiträumen über oder unter einer Referenzspannung liegt, und
die Referenzspannung während einer ersten Detektion des zweiten Satzes von Multi-PAM-Signalen durch den ersten Testempfänger (511) auf einen ersten Pegel gesetzt wird und
die Referenzspannung während einer zweiten Detektion des zweiten Satzes von Multi-PAM-Signalen durch den ersten Testempfänger (511) auf einen zweiten Pegel gesetzt wird.

5. System (500) nach einem der vorstehenden Ansprüche, wobei:
die Testeinrichtung (505) einen zweiten Testtreiber (508) beinhaltet, welcher konfiguriert ist, um Binärsignale zu übertragen, und
die Testschnittstelle (506) einen Schaltkreis (520) beinhaltet, welcher angepasst ist, um Signale, die von den ersten und zweiten Testtreibern (507, 508) ausgegeben werden, zu kombinieren,
so dass eine Ausgabespannung des ersten Testtreibers (507) ungefähr das Zweifache der vom zweiten Testtreiber (508) Ausgegebenen beträgt.

6. System (500) nach Anspruch 1, wobei:
die Vorrichtung (533) einen Empfangsmechanismus (530) beinhaltet, welcher angepasst ist, um den ersten Satz von Multi-PAM-Signalen zu detektieren, und
die Vorrichtung (533) einen Sendemechanismus (544) beinhaltet, welcher mit einem Empfangsmechanismus (530) gekoppelt ist, wobei der Sendemechanismus (544) ausgestaltet ist, um den zweiten Satz von Multi-PAM-Signalen zu erzeugen.

7. System (500) nach Anspruch 6, wobei:
der erste Testempfänger (511) ausgestaltet ist, um den zweiten Satz von Multi-PAM-Signalen durch Detektieren, ob der zweite Satz von Multi-PAM-Signalen während einer ersten Mehrzahl von Zeiträumen über oder unter einem ersten Spannungspegel liegt, zu empfangen,
der erste Testempfänger (511) ausgestaltet ist, um ein Binärsignal mit einem ersten Pegel während eines ersten Zeitraums zu detektieren und die Vorrichtung (533) durch Detektieren des zweiten Satzes von Multi-PAM-Signalen auf Fehler geprüft wird, wobei der erste Testempfänger (511) auf verschiedene Binärsignalpegel gesetzt ist.

8. Verfahren zum Testen einer Multi-PAM-Signalschnittstelle einer Vorrichtung (533) mit einer Testeinrichtung (505), wobei das Verfahren umfasst:
Senden mindestens einer Sequenz von Binärsignalen durch die Testeinrichtung (505),
Umwandeln der Sequenz von Binärsignalen in eine Sequenz von Digitalsignalen,
wobei das Verfahren **gekennzeichnet ist durch**:
Empfangen der der Sequenz von Binärsignalen entsprechenden Sequenz von Digitalsignalen **durch** eine Signalschnittstelle der Vorrichtung (533),
Senden einer der Sequenz von Digitalsignalen entsprechenden Sequenz von Multi-PAM-Signalen **durch** die Multi-PAM-Signalschnittstelle der Vorrichtung (533),
Vergleichen der Sequenz von Multi-PAM-Signalen mit einem ersten Referenzpegel **durch** die Testeinrichtung (505), wobei eine erste Serie von Ergebnissen erhalten wird, und
Vergleichen der ersten Sequenz von Multi-PAM-Signalen mit einem zweiten Referenzpegel **durch** die Testeinrichtung (505), wodurch eine zweite Serie von Ergebnissen erhalten wird.

9. Verfahren nach Anspruch 8, ferner umfassend:
Speichern einer Darstellung der Sequenz von Multi-PAM-Signalen in einem mit der Multi-PAM-Signalschnittstelle assoziierten Speicher (540).

10. Verfahren nach Anspruch 8, ferner umfassend:
Vergleichen der Sequenz von Multi-PAM-Signalen mit einem dritten Referenzpegel durch die Testeinrichtung (505), wodurch eine dritte Serie von Ergebnissen erhalten wird.

11. Verfahren nach Anspruch 8, wobei die Sequenz von Digitalsignalen eine Sequenz von Multi-PAM-Signalen ist.

12. Verfahren nach einem der Ansprüche 8 bis 10, wobei der Schritt des Sendens umfasst: Senden von zwei binären Sequenzen, und
der Schritt des Umwandelns umfasst: Kombinieren der ersten und zweiten Sequenzen von Binärsignalen in eine Sequenz von Digitalsignalen, wobei das Digitalsignal ein Multi-PAM-Signal ist.

## Revendications

1. Système (500) pour tester un dispositif (533) ayant une interface de signal multi-PAM, le système (500) comprenant :
un appareil de test (505) comprenant un premier pilote de test (507) configuré pour transmettre des signaux binaires, un premier récepteur de test (511) configuré pour détecter des signaux numériques, et un mécanisme de comparaison (515) configuré pour déterminer si lesdits signaux numériques correspondent auxdits signaux binaires,
le système (500) étant **caractérisé par**
une interface de test multi-PAM (506) couplée entre le dispositif (533) et ledit appareil de test (505) pour convertir lesdits signaux binaires transmis par ledit appareil de test (505) en une première série des signaux multi-PAM au niveau du dispositif (533), pour recevoir du dispositif (533) une seconde série de signaux multi-PAM produits par le dispositif (533), ladite seconde série de signaux multi-PAM étant basés sur ladite première série des signaux multi-PAM, pour convertir la seconde série de signaux multi-PAM en lesdits signaux numériques, et pour fournir lesdits signaux numériques au dit premier récepteur de test (511),
Dans lequel on recherche les erreurs dans le dispositif (533).

2. Système (500) selon la revendication 1, dans lequel :
ledit appareil de test (505) comprend un second pilote de test (508) pour transmettre des signaux binaires, et ladite interface de test (506) comprend un circuit pour entrer lesdits signaux binaires depuis lesdits premier et second pilotes de test (507, 508) et pour sortir ladite première série de signaux multi-PAM.

3. Système (500) selon la revendication 1 ou 2, comprenant en outre :
un dispositif (533) en cours de test couplé à l'appareil de test (505), dans lequel
le dispositif (533) est adapté pour stocker une représentation de ladite première série de signaux multi-PAM,
le dispositif (533) est adapté pour transmettre à ladite interface de test (506) ladite seconde série de signaux multi-PAM au moins deux fois,
ledit appareil de test (505) est configuré pour détecter un premier niveau de signaux numériques pendant une première fois où ladite seconde série de signaux multi-PAM sont transmis, et
ledit appareil de test (505) est configuré pour détecter un second niveau de signaux numériques pendant une seconde fois où ladite seconde série de signaux multi-PAM sont transmis.

4. Système (500) selon la revendication 1, 2 ou 3, dans lequel :
ledit premier récepteur de test (511) est adapté pour détecter si ladite seconde série de signaux multi-PAM est au-dessus ou au-dessous d'une tension de référence une pluralité de fois, et
ladite tension de référence est réglée à un premier niveau pendant une première détection de ladite seconde série de signaux multi-PAM par ledit premier récepteur de test (511), et
ladite tension de référence est réglée à un second niveau pendant une seconde détection de ladite seconde série de signaux multi-PAM par ledit premier récepteur de test (511).

5. Système (500) selon l'une quelconque des revendications précédentes, dans lequel :
ledit appareil de test (505) comprend un second pilote de test (508) configuré pour transmettre des signaux binaires, et
ladite interface de test (506) comprend un circuit (520) adapté pour combiner des signaux sortis par lesdits premier et second pilotes de test (507, 508),
de telle manière qu'une tension sortie par ledit premier pilote de test (507) est approximativement le double de celle sortie par ledit second pilote de test (508).

6. Système (500) selon la revendication 1, dans lequel :
ledit dispositif (533) comprend un mécanisme de réception (530) adapté pour détecter ladite première série de signaux multi-PAM, et
ledit dispositif (533) comprend un mécanisme de transmission (544) couplé au dit mécanisme de réception (530), ledit mécanisme de transmission (544) étant adapté pour générer ladite seconde série de signaux multi-PAM.

7. Système (500) selon la revendication 6, dans lequel :
ledit premier récepteur de test (511) est adapté pour recevoir ladite seconde série de signaux multi-PAM en détectant si la seconde série de signaux multi-PAM est au-dessus ou au-dessous d'un premier niveau de tension pendant une première pluralité de fois,
ledit premier récepteur de test (511) est adapté pour détecter un signal binaire avec un premier niveau de tension pendant une première période de temps, et on cherche des erreurs dans le dispositif (533) en détectant ladite seconde série de signaux multi-PAM avec ledit premier récepteur de test (511) réglé à différents niveaux de signal binaire.

8. Procédé pour tester une interface de signal multi-PAM d'un dispositif (533) avec un appareil de test (505), le procédé comprenant :
transmettre, par l'appareil de test (505), au moins une séquence de signaux binaires,
convertir la séquence de signaux binaires en une séquence de signaux numériques,
le procédé étant **caractérisé par** :
recevoir, par une interface de signal du dispositif (533), la séquence de signaux numériques correspondant à ladite séquence de signaux binaires,
transmettre, par l'interface de signal multi-PAM du dispositif (533), une seconde séquence de signaux multi-PAM correspondant à ladite séquence de signaux numériques,
comparer, par l'appareil de test (505), ladite séquence de signaux multi-PAM avec un premier niveau de référence, obtenant ainsi une première série de résultats, et
comparer, par l'appareil de test (505), ladite séquence de signaux multi-PAM avec un second niveau de référence, obtenant ainsi une seconde série de résultats.

9. Procédé selon la revendication 8, comprenant en outre de stocker, dans une mémoire (540) associée à l'interface de signal multi-PAM, une représentation de ladite séquence de signaux multi-PAM.

10. Procédé selon la revendication 8, comprenant en outre :
comparer, par l'appareil de test (505), ladite séquence de signaux multi-PAM à un troisième niveau de référence, obtenant ainsi une troisième série de résultats.

11. Procédé selon la revendication 8, dans lequel la séquence de signaux numériques est une séquence de signaux multi-PAM.

12. Procédé selon l'une quelconque des revendications 8 à 10, dans lequel
la première étape de transmission comprend de transmettre deux séquences binaires, et
l'étape de conversion comprend de combiner les première et seconde séquences de signaux binaires dans une séquence de signaux numériques, dans lequel le signal numérique est un signal multi-PAM.
